(19) Europäisches Patentamt / European Patent Office / Office européen des brevets

(11) **EP 4 600 739 A2**

(12) **EUROPEAN PATENT APPLICATION**

(43) Date of publication:
**13.08.2025 Bulletin 2025/33**

(21) Application number: **25185449.3**

(22) Date of filing: **26.06.2025**

(51) International Patent Classification (IPC):
*G03F 7/00* $^{(2006.01)}$

(52) Cooperative Patent Classification (CPC):
**G03F 7/706839**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicant: **ASML Netherlands B.V.
5500 AH Veldhoven (NL)**

(72) Inventors:
• **ISOLA, Alfonso, Agatino
5500 AH Veldhoven (NL)**
• **KOK, Gijs
5500 AH Veldhoven (NL)**

(74) Representative: **ASML Netherlands B.V.
Corporate Intellectual Property
P.O. Box 324
5500 AH Veldhoven (NL)**

(54) **METROLOGY METHOD AND METROLOGY APPARATUS**

(57) Disclosed is a method of determining a respective representative measurement value for one or more regions of interest within at least one image of a metrology target representative of light diffracted by the target. The method comprises obtaining metrology data describing the at least one image; fitting a model to the metrology data in the one or more regions of interest of the at least one image, the model comprising at least a zero frequency term and an oscillatory term; and determining the representative measurement value for the one or more regions of interest from the fitted model.

Fig. 6

**Description**

FIELD OF THE INVENTION

The present invention relates to a method of metrology in the context of monitoring a lithographic process.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., gratings of 40$\mu$m by 40$\mu$m and the measurement beam generates a spot that is smaller than the grating (i.e., the grating is underfilled). This simplifies mathematical reconstruction of the target as it can be regarded as infinite. However, in order to reduce the size of the targets, e.g., to 10$\mu$m by 10$\mu$m or less, e.g., so they can be positioned in amongst product features, rather than in the scribe lane, metrology has been proposed in which the grating is made smaller than the measurement spot (i.e., the grating is overfilled). Typically such targets are measured using dark-field scatterometry in which the zeroth order of diffraction (corresponding to a specular reflection) is blocked, and only higher orders processed. Examples of dark-field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In a known dark-field metrology technique, hereafter referred to as $\mu$DBO (micro diffraction -based overlay), measurement results are obtained by measuring a metrology target to obtain the -1 and the +1 diffraction order intensities. In order to block other higher diffraction orders ($\pm$2, $\pm$3 etc), dark-field systems may be physically designed with apertures or filters to allow light within a specific angular range. The intensity asymmetry, a comparison of these -1 and +1 diffraction order intensities, in the metrology target can be used as an indicator of the parameter of interest (e.g., overlay, dose or focus), where overlay describes an undesired misalignment of two layers, and focus and dose describe the focus and dose of the exposure when exposing the metrology target.

In such dark-field metrology, there is an effective limit on the wavelength-to-pitch ratio, with the pitch referring to the pitch of the metrology target gratings, and therefore a limit on measurable target pitches for a given illumination wavelength in a dark-field system with a given detection aperture, due to the need to acquire only first order diffraction from the targets, with no additional higher orders. Correspondingly there is also an effective limit on usable illumination wavelengths for a given target pitch.

It is desirable to increase the range of pitches measurable for a given wavelength and/or the range of wavelengths usable to measure a given pitch, in metrology techniques such as $\mu$DBO metrology. In particular, it is desirable to increase the range of pitches and/or range of wavelengths measurable in $\mu$DBO metrology using one or more of: present parameter of interest inference methods, present target designs and/or present scatterometry apparatuses.

Alternatively or in addition it is desirable to account for tool induced distortions in metrology.

# EP 4 600 739 A2

## SUMMARY OF THE INVENTION

The invention in a first aspect provides a method of determining a respective representative measurement value for one or more regions of interest within at least one image of a metrology target representative of light diffracted by the target, the method comprising: obtaining metrology data describing the at least one image; fitting a model to the metrology data i the one or more regions of interest of the at least one image, the model comprising at least a zero frequency term and an oscillatory term; and determining the representative measurement value for the one or more regions of interest from the fitted model.

The invention in a second aspect provides a respective computer program and in a third aspect a metrology apparatus.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

## BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3 comprises (a) a schematic diagram of an inspection apparatus according to a first embodiment of the invention, (b) a representation of a substrate W and target T in a first orientation, (c) representation of the substrate W and target T in a second orientation, (d) schematic illustration of the capture of a +1 diffraction order with a substrate in the first orientation (e) and schematic illustration of capture of a -1 diffraction order with the substrate in the second orientation;
Figure 4 depicts a known form of a multiple grating target and an outline of a measurement spot on a substrate;
Figure 5 depicts an image of the target of Figure 4 obtained in the inspection apparatus of Figure 3(a); and
Figure 6 depicts an image of the target of Figure 4 obtained in the inspection apparatus of Figure 3(a) when a second diffraction order is captured in addition to a first diffraction order resulting in interference.

## DETAILED DESCRIPTION OF EXEMPLARY EMBODIMENTS

Before describing embodiments of the invention in detail, it is instructive to present an example environment in which embodiments of the present invention may be implemented.

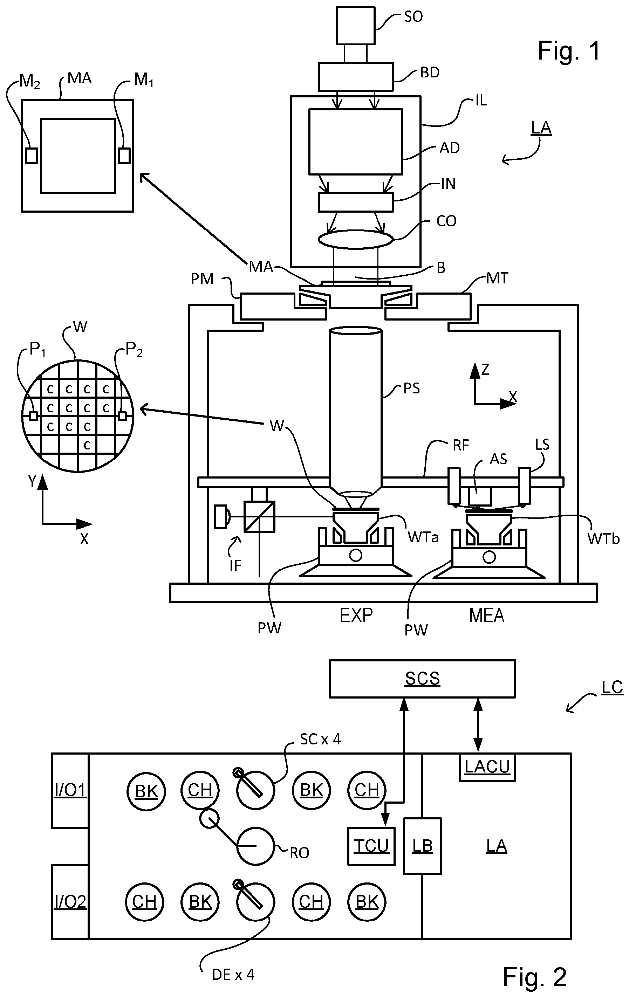

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W. In addition, the lithographic apparatus includes a reference frame RF.

The illumination optical system may include various types of optical or non-optical components, such as refractive, reflective, magnetic, electromagnetic, electrostatic or other types of components, or any combination thereof, for directing, shaping, or controlling radiation.

The patterning device support MT holds the patterning device MA in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WTa, WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features.

Lithographic apparatus LA in this example is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

EP 4 600 739 A2

The terms "radiation" and "beam" used herein in the context of lithography encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of components, including refractive, reflective, magnetic, electromagnetic and electrostatic components.

As shown in Figure 2, the lithographic apparatus LA forms part of a lithographic system, referred to as a lithographic cell LC or a lithocell or a cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by a supervisory control system SCS, which also controls the lithographic apparatus via a lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which the lithocell LC is located also includes a metrology system which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within the metrology system, an inspection (or metrology) apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

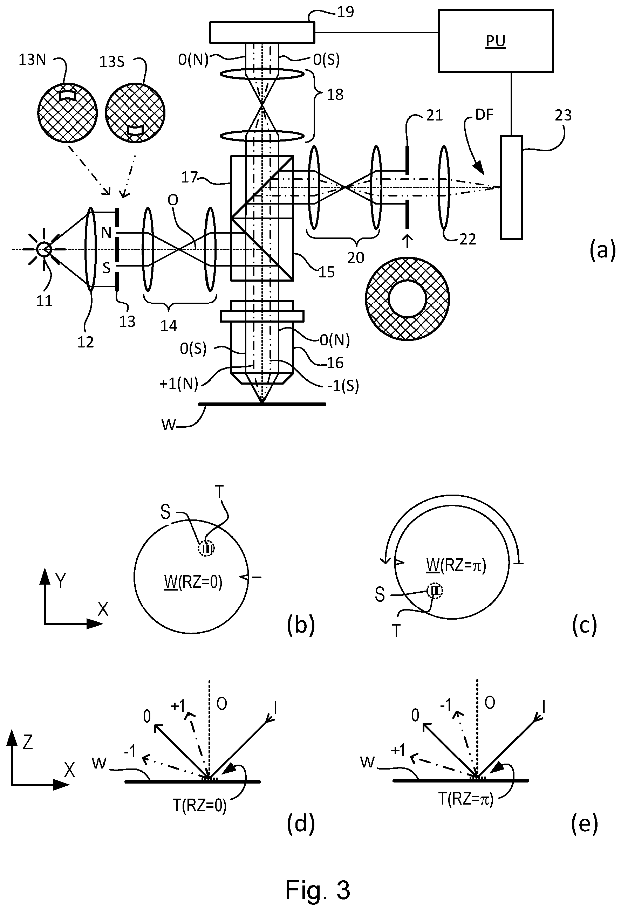

An inspection (or metrology) apparatus is shown in Figure 3(a). A target T and diffracted rays of measurement radiation used to illuminate the target are illustrated in more detail in Figures 3(b), 3(c), 3(d), 3(e). The metrology apparatus illustrated is of a type known as a dark-field metrology apparatus. The metrology apparatus depicted here is purely exemplary, to provide an explanation of dark-field metrology. The metrology apparatus may be a stand-alone device or incorporated in either the lithographic apparatus LA, e.g., at the measurement station, or in the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

In Figure 3(b), we see an example target T on a substrate W brought into measurement field S in a first orientation, which we can define by a rotation angle RZ of zero degrees (RZ=0). In Figure 3(c) we see the same target T of substrate W brought into measurement field S with a rotation of 180 degrees (RZ=$\pi$ in radians). It will be understood that the sizes of measurement field S and target T here are greatly exaggerated for the sake of illustration. A real substrate may have many targets distributed across it, for measuring overlay and other parameters at different positions on the substrate. The diameter of measurement field S may be for example between 10 and 50 $\mu$m, while the target T fits within the measurement field diameter in this type of small target metrology. The target is thus referred to as "overfilled".

Figures 3 (d) and 3(e) show schematically more detail of the diffraction spectrum that results when a periodic structure (grating) of target T is placed into measurement field S with substrate W normal to the optical axis O of objective lens 16, for the measurement examples of Figure 3(b) and 3(c) respectively. In Figure 3(d) the orientation RZ=0 is used, while in Figure 3(e) the 180 degree rotated orientation is used (RZ=$\pi$). In each case, the target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). The two first order rays are reversed for each of the two wafer rotations. It should be remembered that with an overfilled small target, these rays are just one of many parallel rays covering the area of the substrate W including metrology target T and other features. Since the aperture in plate 13 (see Fig. 3(a)) has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a), 3(d) and 3(e) are shown somewhat off axis, purely to enable them to be more easily distinguished in the diagram.

At least the 0 and +1/-1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target T on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

As such, the particular forms of aperture plate 13 and field stop 21 shown in Figure 3(a) are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

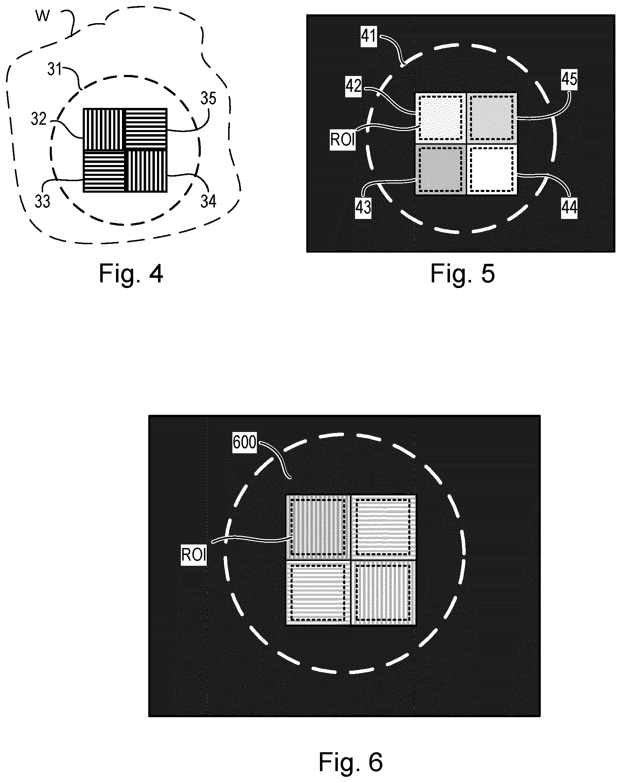

Figure 4 depicts an overlay target or composite overlay target formed on a substrate according to known practice.

The overlay target in this example comprises four sub-targets (e.g., gratings) 32 to 35 positioned closely together so that they will all be within a measurement spot 31 formed by the illumination beam of the metrology apparatus. The four sub-overlay targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3. While the pupil plane image sensor 19 cannot resolve the different individual sub-targets 32 to 35, the image sensor 23 can do so. The hatched circular area 41 represents the field of the image on the sensor, within which the illuminated spot 31 on the substrate is imaged. Within this, rectangular areas 42-45 represent the images of the small overlay target sub-targets 32 to 35. If the overlay targets are located in product areas, product features may also be visible in the periphery of this image field. Image processor and controller PU of the apparatus of Fig. 3(a) processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay sub-targets have been identified, the intensities of those individual images can be measured, e.g., by averaging or summing selected pixel intensity values within each identified area, often referred to as a region of interest (ROI). Intensities and/or other properties of the images can be compared with one another. These results can be combined to measure different parameters of the lithographic process. Overlay performance is an important example of such a parameter. Although the ROIs are illustrated in Fig. 5 as square areas within each sub-target, cutting off the edge signal, in practice it may be decided to evaluate image intensity within a ROI of a different shape, or of a different size, depending on for instance, signal quality and in particular edge effects.

Because each of the top and bottom gratings of a metrology target use identical pitch values in $\mu$DBO, the two first diffraction orders (i.e., +1 and -1 orders) emerging respectively from the top and bottom gratings have identical angles and therefore no interference is produced (i.e., no intensity fringe patterns). This means that there is little variation in measured intensity per sub-target over all 2-D pixel positions (x, y) of the image; i.e., it comprises substantially only an intensity DC (i.e. zero-frequency) term $C_0(OV)$, which encodes the overlay (OV) information (or more generally information on a parameter of interest); i.e.,: $I_1(x, y) \approx C_0(OV)$.

The first diffraction order intensity asymmetry signal $\Delta I(OV)$ can be generally described by the following well-known formula:

$$\Delta I(OV) = I_{+1}(OV) - I_{-1}(OV) = \sum_{m=1}^{\infty} K_m \sin\left(2\pi m \frac{OV}{p}\right) \qquad [1]$$

where $I_{+1}(OV)$ is the intensity of the +1 diffraction order, $I_{-1}(OV)$ is the intensity of the -1 diffraction order, OV is overlay (parameter of interest), p is the target grating pitch, m is the diffraction order integer, $K_m$ is an unknown proportionality constant (overlay proportionality term) per diffraction order.

In Equation [1], the intensity asymmetry is represented as summation of multiple harmonics of the overlay phase. All higher intra-stack diffraction orders can cause higher overlay harmonics. However, these higher overlay harmonics are typically weak due to the sinc-like fall-off of the higher diffraction orders, i.e., the value of overlay proportionality term $K_m$ decreases quickly in magnitude with increasing m. Truncating this infinite summation to the first M terms would lead to M+1 unknowns, i.e $\{OV, K_1, K_2, ... , K_M\}$. As such, to solve the related linear system requires M+1 unique intensity asymmetry signals.

In principle, multiple higher diffraction orders may be used to compute the first diffraction order intensity asymmetry signal. However, this would require a $\mu$DBO mark with multiple biases to solve for several $K_m$, which is undesirable due to the increase in target size and reticle/substrate real-estate (i.e., area).

However, because of the given progressively reduced magnitude of all higher order reflectivities and transmittivities diffracting from bottom and top gratings, a lowest order diffraction efficiency (DE) approximation is commonly applied. In this approximation, only the contribution from reflectivities and transmittivities with order $\leq$1 are taken into account to describe the total reflectivity of the $\mu$DBO mark in the +/-1st order. This leads to a first diffraction order intensity asymmetry consisting of a single sine-harmonic of the overlay phase, i.e. m=1:

$$\Delta I(OV) = I_{+1}(OV) - I_{-1}(OV) = K \sin\left(2\pi \frac{OV}{p}\right) \qquad [2]$$

In Equation [2], the measured intensity asymmetry is function of two unknowns, overlay OV (the parameter of interest) and the overlay proportionality term K. Therefore, in order to uniquely infer the overlay value *OV,* two first order intensity asymmetries $\Delta I^{(PB)}$ and $\Delta I^{(NB)}$ at two distinct mark locations are measured, where the superscripts refer to the positive (PB) and negative (NB) biased sub-targets (as described in relation to Figure 4 with biases +d, -d)), leading to the following linear system:

$$\begin{cases} \Delta I^{(PB)} + \Delta I^{(NB)} = 2K \cos\left(\frac{2\pi}{p}b\right) \sin\left(\frac{2\pi}{p}OV\right) \\ \Delta I^{(PB)} - \Delta I^{(NB)} = 2K \sin\left(\frac{2\pi}{p}b\right) \cos\left(\frac{2\pi}{p}OV\right) \end{cases} \qquad [3]$$

where b is the magnitude of a bias shift applied to the gratings, e.g. a shift applied to the top layer grating with respect to the bottom layer grating. Typically, as has been described in relation to Figure 4, this bias is equal in magnitude and opposite in direction (i.e., +b, -b) for each sub-target pair (i.e., per direction). This is not essential, however; all that is required is for the bias to be different for each sub-target per pair.

By solving the linear system at Equation [3] with respect to the overlay value OV, the well-known μDBO "overlay arctan model" formula can be obtained:

$$OV = \frac{p}{2\pi} \tan^{-1}\left(\frac{\Delta I^{(PB)} + \Delta I^{(NB)}}{\Delta I^{(PB)} - \Delta I^{(NB)}} \cdot \tan\left(\frac{2\pi}{p}b\right)\right) \approx b \frac{\Delta I^{(PB)} + \Delta I^{(NB)}}{\Delta I^{(PB)} - \Delta I^{(NB)}} \qquad [4]$$

noting that the final linear approximation is valid only when both the overlay OV and the bias b are much smaller than the grating pitch p.

In order to ensure that only first diffraction order radiation is present for the acquired intensity images, present metrology tools such as illustrated in Figure 3(a) have a present effective wavelength-to-pitch $\lambda/p$ limitation in the range $0.75 \leq \frac{\lambda}{p} \leq 1.35$, where $\lambda/p$ is the wavelength $\lambda$ to target pitch p ratio. There is no diffraction above the upper limit, while second diffraction orders will be captured with the first diffraction orders below the lower limit. Therefore, for a given wavelength, smaller pitches cannot be measured as diffraction orders higher than the zeroth are not generated, while larger pitches result in the detected radiation comprising diffraction orders >1, e.g., second diffraction order radiation. The concepts disclosed herein aim to address this latter limitation and therefore allow metrology on larger pitches without a change in measurement wavelength, metrology apparatus hardware, target design, nor overlay inference method (e.g., Equation [4]). Alternatively or in addition, the concepts disclosed herein allow metrology to be performed using a larger range of possible measurement wavelengths for a given target pitch.

When larger pitch values or smaller wavelengths are used for metrology measurements which take the wavelength-to-pitch ratio to outside present effective range, multiple higher diffraction orders (i.e., of different order such as first order and second order diffraction) from the bottom and top gratings are captured resulting in interference fringe patterns being visible in the intensity images. These interferences are caused by the different orientation of the multiple diffraction order fields diffracting from the top and bottom gratings. Interference fringe patterns may also be visible when the detection branch is designed (such as aperture stop 21 of Fig. 3 designed with a large aperture size) to allow capture of higher diffraction orders. Also, interference fringe patterns due to interference of multiple same diffraction orders (e.g ±1) may also be visible when dark-field scatterometry setup is used to measure targets comprising superposed gratings with different pitches (such as in continuous diffraction-based overlay (cDBO) targets).

Figure 6 is a schematic illustration of an image 600, equivalent to that shown in Figure 5, but where second diffraction orders have also been captured in μDBO. Interference fringes are visible, instead of the largely flat intensity images (per sub-target) of Figure 5.

In particular, when both the ±1 and ±2 diffraction orders are acquired, the measured intensity $I_{1,2}(x, y)$ at the camera plane (*x, y*) can be described as contribution of two terms which are both a function of the unknown overlay:

$$I_{1,2}(x,y) \approx C_0(OV) + C_1 \cos\left(\frac{2\pi}{p}x + \varphi(OV)\right) \qquad [5]$$

where $C_0$ and $C_1$ are process-related constant terms, p is the fringe pitch (equal to the target grating pitch), and $\varphi$ is the phase offset.

In Equation [5], $C_0(OV)$ is the zero-frequency intensity term consisting of all DC contributions of all first and second diffraction orders coming from the top and bottom gratings. As in the standard case when the first diffraction order only is acquired, this intensity background DC term $C_0$ encodes the overlay information. This DC term $C_0$ can be extracted for all (positive and negative biased) sub-targets (i.e., a respective region of interest for each sub-target) from all normal (i.e., +1 diffraction order) and complementary (i.e., -1 diffraction order) intensity images, and be used for overlay computation by applying Equation [4]. It is this term that is of interest and will be used to determined overlay.

The second term of Equation [5] represents an intensity oscillatory term with amplitude given by a second process-related constant $C_1$, a fringe period which is equal to the grating pitch p, and a phase $\varphi(OV)$ which also encodes the overlay information. This oscillatory term is the cause of the fringe pattern visible on Figure 6; it comprises all of the interferences between the first and second diffraction orders coming from the top and bottom gratings.

The standard µDBO algorithm cannot properly handle more than the first diffraction order. However, a µDBO "large pitch" algorithm has been described in US12130246B2, which may be applied whenever the selected wavelength-to-pitch ratio $\lambda/p$ is smaller than a given threshold, i.e., when the dark-field camera image also comprises second diffraction order radiation.

Briefly, the µDBO "large pitch" method applies a digital filtering method to extract the background intensity $C_0$(OV) for the positive bias PB and negative bias NB sub-targets of the normal/complementary images. The finally convolved "flattened" images can be then used to compute overlay by applying the standard µDBO pattern recognition method. In this approach, the known period of the oscillatory term at Equation [5] (i.e., the grating pitch) is exploited to cancel out the fringes from the intensity images. The DC term is then extracted by simply integrating the intensity images over an integer number of this grating pitch p. This makes the oscillatory cosine term vanish, yielding:

$$I_{1,2}^{integrated}(x) \approx C_0(OV) \qquad [6]$$

It can be appreciated that the asymmetries computed for the integrated intensities yielded by Equation [6] scale linearly with the induced overlay in a manner similar to that of conventional overlay metrology. Hence, once the integration has been performed, the integrated intensities for all biased sub-targets can be input into Equation [4] to infer overlay.

Unfortunately, in its actual implementation, the aforementioned image integration is performed via convolving the intensity image with a box blur filter using a convolution kernel size (in pixels) which is rounded to the nearest odd number of pixels. This rounding operation of the integration kernel size introduces a discretization error that hampers the exact cancellation of the oscillatory term, such that the cosine integration is not perfectly zero. As a result, the diffraction interference fringes are not completely removed and remain clearly visible in the convolved image. Furthermore, the µDBO "large pitch" algorithm presents other deficiencies. For example, the box convolution produces more edges artifacts along mark pads boundaries. Also, a potential camera magnification effect could negatively affect the convolution operation.

These deficiencies can seriously impact the µDBO pattern recognition, such that overlay inference accuracy is negatively impacted, in addition to robustness and repeatability performance.

To address the issues described, a fitting method is proposed to extract the DC (zero-frequency) background intensity term from the µDBO target intensity images. All DC contributions of all first and second diffraction orders coming from the top and bottom gratings within a region of interest form together a representative measurement value for the respective region of interest. The fitting method can be used for both usage scenarios described above: i.e., conventional µDBO where only first diffraction order radiation is captured (and therefore no interference fringe is present in the resulting image), or where both first and second diffraction orders are captured (resulting in interference fringes). This means that there is no need to select (either manually or automatically) between different measurement modes depending on target pitch and/or measurement wavelength. Additionally, as will be described later, the fitting method can also be used for other applications where interference of same diffraction orders is captured in the image, such as cDBO using superposed gratings having different pitches.

The fitting method may comprise a fitting of the cosine-based intensity model of Equation [5] (or model based thereon) to the µDBO target intensity images to extract the first term $C_0(OV)$, i.e., per region of interest, where each region of interest may relate to a respective different sub-target of each of the normal and complementary images.

As such, the proposed method determines a respective representative measurement value for one or more regions of interest within at least one image of a metrology target representative of light diffracted by the target, where the method comprises: obtaining metrology data describing the at least one image; fitting a model to the metrology data in the one or more regions of interest, the model comprising at least a zero frequency term and an oscillatory term; and determining the representative measurement value for the one or more regions of interest from the fitted model.

The at least one image may comprise a dark-field image comprising an image of only a single diffraction order (such as the -1 and +1 order) in which case the image shows no interference fringe or an image of at least two diffraction orders (e.g., a first order and second order such as the +1 and +2 orders or the -1 and -2 orders) leading to interference fringes in the resulting image. In the case of cDBO described later, the dark-field image comprising an image of only a single diffraction order will show interference fringes due to the design of the cDBO target with superposed gratings having different pitches.

In performing this fitting, it can be appreciated that the image pixel positional coordinate y may optionally be neglected since the fringes only occur along the x-direction (direction of periodicity of the fringes), and no frequency contribution is provided along the y-direction.

The overlay extraction method of Equation [4] requires the extraction of the intensity DC terms $C_0^{PB,N}, C_0^{NB,N}, C_0^{PB,C}$ and $C_0^{NB,C}$ from the two positive biased PB and negative biased NB sub-targets of the normal N (positive diffraction orders, e.g., +1, +2) and complementary C (negative diffraction orders, e.g., -1, -2) images, these DC terms being identified by the superscripts (e.g., $C_0^{PB,N}$ is the DC term from the normal image or +1, +2 image of the positive biased PB sub-target, etc.).

This task can be formulated as a fitting problem in which a sine or cosine function is optimally registered to the intensity images. Taking for example the intensity profile of the positive biased PB sub-target of the normal image N, Equation [5] can be recast as:

$$I_N^{PB}(x,y) \approx C_0^{PB,N} + C_1^{PB,N} cos\left(\frac{2\pi}{p}x + \varphi_N^{PB}\right)$$

$$= C_0^{PB,N} + C_1^{PB,N} cos\left(\frac{2\pi}{p}x\right)cos(\varphi_N^{PB}) - C_1^{PB,N} sin\left(\frac{2\pi}{p}x\right)sin(\varphi_N^{PB}) \qquad [7]$$

By representing the unknowns conveniently as:

$$v_0 = C_1^{PB,N}cos(\varphi_N^{PB}), \quad v_1 = C_1^{PB,N}sin(\varphi_N^{PB}), \qquad v_2 = C_0^{PB,N} \qquad [8]$$

Equation [7] can be rewritten to separate knowns and unknowns, given an $((x_i, y_i), I_i)$ pair of camera $(x_i, y_i)$-position and corresponding camera intensity at i-th pixel, as:

$$I_i = I_N^{PB}(x_i, y_i) = v_0 cos\left(\frac{2\pi}{p}x_i\right) - v_1 sin\left(\frac{2\pi}{p}x_i\right) + v_2 \qquad [9]$$

This can be converted into a matrix form, where every row represents a pixel:

$$Hv = I$$

$$\begin{bmatrix} cos\left(\frac{2\pi}{p}x_1\right) & -sin\left(\frac{2\pi}{p}x_1\right) & 1 \\ cos\left(\frac{2\pi}{p}x_2\right) & -sin\left(\frac{2\pi}{p}x_2\right) & 1 \\ \vdots & \vdots & \vdots \\ cos\left(\frac{2\pi}{p}x_N\right) & -sin\left(\frac{2\pi}{p}x_N\right) & 1 \end{bmatrix} \begin{bmatrix} v_0 \\ v_1 \\ v_2 \end{bmatrix} = \begin{bmatrix} I_1 \\ I_2 \\ \vdots \\ I_N \end{bmatrix} \qquad [10]$$

where the H matrix or model matrix comprises known parameters, the *v* vector is the unknowns vector (with unknown coefficients) being solved for and the I vector is the measurements vector (vector of measured intensities).

The linear system at Equation [10] can be solved by taking the pseudo-inverse of the *H* matrix:

$$v = H^{-1}I \qquad [11]$$

Finally, the solution of Equation [11] can be used to retrieve $C_0^{PB,N}, C_1^{PB,N}$ and $\varphi_N^{PB}$ as:

$$\varphi_N^{PB} = arctan2(v_0, v_1), \quad C_1^{PB,N} = \sqrt{v_0^2 + v_1^2}, \quad C_0^{PB,N} = v_2 \quad [12]$$

By applying the same fitting method to all of the regions of interest, wherein each region of interest respectively relates to the normal N and complementary C images of the positive biased and negative biased sub-targets (i.e., repeating the above steps for all sub-targets for each of the normal and complementary images), all four DC terms $C_0^{PB,N}, C_0^{NB,N}, C_0^{PB,C}$ and $C_0^{NB,C}$ can be retrieved (e.g., per measurement direction). Once retrieved, these can be used to determine overlay, e.g., using the Equations [2], [3], and [4]. This may comprise using these retrieved DC terms as respective single representative measurement value for their corresponding region of interest.

This approach shows superior performance in determining overlay when first and second diffraction orders are captured, compared to present methods such as described above. Additionally, this fitting approach provides at least equal performance as the present conventional method when only a single diffraction order is captured. Therefore, this approach may be employed for all pitches/wavelengths (i.e., provided that the measurement radiation is diffracted).

The above methods have been disclosed in terms of measuring overlay. However, methods disclosed herein are applicable for any method for which a single intensity value is desired for a target or sub-target, for which a captured image may be impacted by an oscillatory term and therefore fringes due to two higher orders being captured per (normal and complementary) image. Another parameter of interest may be focus and/or dose, which may be measured using micro-diffraction based focus ($\mu$DBF) targets. These targets may be formed via grating features on the reticle which have sub-resolution features. These sub-resolution features affect the symmetry of the imaged target on the substrate in dependence of focus. By measuring the asymmetry of the imaged target in the same way as for overlay as already described, i.e., via measuring an intensity difference of higher diffraction orders, the exposure focus (and/or dose) when the target was imaged can be inferred.

The concepts disclosed above are described in terms of overlay metrology in the context of, for example, production substrates. However, the methods disclosed are equally applicable to measuring a parameter of interest (e.g., overlay) from special monitor substrates; e.g., as used for monitoring drift from a baseline performance of a lithographic apparatus and/or to match performance of different lithographic apparatuses. These monitor substrates typically comprise a large number of targets, so as to enable dense metrology. In contrast to production overlay metrology which as typically performed on small targets which are overfilled by the measurement spot (i.e., smaller than the spot), the monitor substrates may comprise larger targets which are underfilled by the spot. This means that a circular region of interest may be extracted instead of a rectangular region of interest. Because these targets typically have a pitch on the order of $1\mu$m, they are presently measured using small-angle apertures with the intention of preventing second orders being detected. However, the proposed fitting method will enable such targets to be measured them using regular (larger) apertures, as now the effect of the resultant fringes appearing on the images due to the captured second orders can be removed in computing a parameter of interest.

A number of refinements to this concept will now be described. In one such embodiment, instead of considering the DC term $C_0$ to comprise a constant two-dimensional 2-D intensity profile, it may be represented as a more flexible 2-D spatial basis function expansion. Such a 2-D spatial basis function expansion may comprise radial basis functions, 2D polynomials, and/or a combination of these, to obtain a 2D spatial basis function expanded zero frequency term.

Using a specific example of a polynomial expansion (e.g., up to 6 terms although this may be more or less), including polynomial orders bigger than zero over both x and y directions, the linear system at Equation [10] can be rewritten as:

$$Y = Hv = [H_{osc} \ H_{DC}]v =$$

$$\begin{bmatrix} cos\left(\frac{2\pi}{p}x_1\right) & -sin\left(\frac{2\pi}{p}x_1\right) & 1 & x_1 & y_1 & x_1 y_1 & x_1^2 \dots x_1^M & y_1^M \\ cos\left(\frac{2\pi}{p}x_2\right) & -sin\left(\frac{2\pi}{p}x_2\right) & 1 & x_2 & y_2 & x_2 y_2 & x_2^2 \dots x_2^M & y_2^M \\ & & \vdots & & \vdots & & \vdots & \\ cos\left(\frac{2\pi}{p}x_N\right) & -sin\left(\frac{2\pi}{p}x_N\right) & 1 & x_N & y_N & x_N y_N & x_N^2 \dots x_N^M & y_N^M \end{bmatrix} \begin{bmatrix} v_0 \\ v_1 \\ v_2^1 \\ v_2^2 \\ \vdots \\ v_2^M \end{bmatrix} = \begin{bmatrix} y_1 \\ y_2 \\ \vdots \\ y_N \end{bmatrix} \quad [13]$$

where the linear system matrix $H$ now comprises two submatrices $H_{osc}$ and $H_{DC}$ related to the intensity oscillatory and "DC" (zero-frequency) terms, respectively (the latter now not truly a DC term as it comprises a contribution of the constant and higher polynomial terms on x- and y- directions). This more flexible 2-D representation of the intensity DC term $C_0(x, y)$ can result in a better fit to the 2-D background intensity, e.g., when it is affected by secondary nuisances such as: edge artifacts, cross talk, grating imbalance, background grating asymmetries, etc.. It can be readily appreciated that, in general, the $H_{DC}$ sub-matrix can be customized to any type of 2D spatial basis function family.

A single representative measurement value can be determined from the 2-D polynomial DC term $C_0(x, y)$ (or more generally from the fitted 2D spatial basis function expanded zero frequency term), e.g., as an average over x, y, which can then be used to determine overlay as before (i.e., determined for each sub-target per normal and complementary images via Equation [4]).

As an alternative or in addition to a polynomial expansion of the DC term, the oscillatory term may be expanded to comprise multiple harmonics; i.e., one or more higher harmonics in addition to the single (first) harmonic with period p. In most cases this single harmonic is sufficient as it is by far the more dominant, particularly when stacks are conventionally thick. However, for particularly thick stacks as may sometimes be encountered, at least one higher intensity oscillatory harmonic may be comprised within the captured image. In such an example, Equation [5] may be amended to comprise multiple harmonics at period $p/i$, with $\forall i \in \mathbb{N} \ast = \{1, 2, 3 \ldots\}$ :

$$I_{1,2}(x, y) \approx C_0(OV) + \sum_{i=1}^{n} C_i \cos\left(\frac{2i\pi}{p}x + \varphi(OV)\right) \quad [14]$$

In a specific example, n may be 2. This is likely to be sufficient as there is unlikely to be more than a second harmonic significantly present even for thick stacks. In such a case, the H matrix of Equation [10] or [13] may comprise two additional columns for additional oscillatory terms $\cos\left(\frac{4\pi}{p}x_i\right)$ and $-\sin\left(\frac{4\pi}{p}x_i\right)$ with Vi = 1, ... , N.

Due to the potential presence of edge artifacts in the captured images, it may be advantageous in some circumstances to provide a pixelwise weighting window mask as an additional input to the fitting problem. Such a mask, for example, may comprise binary or apodization masks (i.e., comprising values ranging in [0,1]). The mask may, for example, be a trapezoidal weighting mask. A weighting window mask can help to suppress or reduce the contribution of edge pixels (i.e., pixels in the vicinity of each sub-target boundary) to the fitting problem solution.

Such a weighting window mask w may be incorporated into the linear system represented by Equation [10] (or Equation [13] and/or being adapted to include additional oscillatory terms), e.g., according to:

$$w \odot Hv = w \odot I \quad [15]$$

and therefore can be solved by taking the pseudo-inverse of the weighted system matrix $w \odot H$:

$$v = (w \odot H)^{-1}(w \odot I) \quad [16]$$

It can be appreciated that in the abovementioned monitoring substrate embodiment, a weighted mask with a circular shape may be used, e.g., to match the circular region of interest.

In a further refinement, which may be used with any of the examples described above, the linear system of Equation [10] can be extended to incorporate one or more known tool induced distortions, such as, for example, fringe magnification and/or fringe rotation. An expanded cosine-fitting model adapted to comprise one or more known tool induced distortions has been shown to improve the dynamic precision and matching.

In a first tool induced distortion example, the cosine model of Equation [5] may incorporate fringe frequency magnification as a multiplicative magnification factor m within the frequency term of the cosine:

$$I_{1,2}(x, y) \approx C_0 + C_1 \cos\left(\frac{2\pi}{p}mx + \varphi\right) \quad [17]$$

Alternatively, or additionally, the rotation of the intensity fringes can be represented using the well-known rotation $R(\theta)$ matrix in $\mathbb{R}^2$ :

$$\begin{bmatrix} x' \\ y' \end{bmatrix} = R(\theta)\begin{bmatrix} x \\ y \end{bmatrix} = \begin{bmatrix} \cos(\theta) & -\sin(\theta) \\ \sin(\theta) & \cos(\theta) \end{bmatrix}\begin{bmatrix} x \\ y \end{bmatrix} \quad [18]$$

As such, an extended intensity fringe model including both rotation and magnification (each may be incorporated independently) can be formulated as:

$$I(x', y') = I\left(R(\theta)\begin{bmatrix}x\\y\end{bmatrix}\right) \approx C_0 + C_1\cos\left(\frac{2\pi}{p}mx + \varphi\right) \qquad [19]$$

Converting this formula into matrix form to obtain an equivalent to Equation [10], yields:

$$H(m)v = I(\theta)$$

$$\begin{bmatrix} \cos\left(\frac{2\pi}{p}mx_1\right) & -\sin\left(\frac{2\pi}{p}mx_1\right) & 1 \\ \cos\left(\frac{2\pi}{p}mx_2\right) & -\sin\left(\frac{2\pi}{p}mx_2\right) & 1 \\ \vdots & \vdots & \vdots \\ \cos\left(\frac{2\pi}{p}mx_N\right) & -\sin\left(\frac{2\pi}{p}mx_N\right) & 1 \end{bmatrix} \begin{bmatrix}v_0\\v_1\\v_2\end{bmatrix} = \begin{bmatrix}I_1(\theta)\\I_2(\theta)\\\vdots\\I_N(\theta)\end{bmatrix} = \begin{bmatrix}I\left(R(\theta)\begin{bmatrix}x_1\\y_1\end{bmatrix}\right)\\I\left(R(\theta)\begin{bmatrix}x_2\\y_2\end{bmatrix}\right)\\\vdots\\I\left(R(\theta)\begin{bmatrix}x_N\\y_N\end{bmatrix}\right)\end{bmatrix} \qquad [20]$$

In contrast to Equation [10], the linear system matrix H(m) of Equation [20] is additionally parameterized by the magnification factor m, and therefore both the magnification factor m and rotation angle θ also require optimization, when optimally fitting the measured intensity profiles. Because of this, the fitting problem has now an extended unknown vector $[v_0, v_1, v_2, m, \theta]$ which cannot be solved via simple pseudo-inverse matrix computation.

A suitable method to solve the linear system of Equation [20] may comprise defining the related fitting problem as a numerical optimization problem and applying a mathematical optimizer to find the problem solution via minimizing the residual between the fitted model outputs and the measured data. For example, a residual least square function may be defined as:

$$F(v, m, \theta) = \frac{1}{2}\sum_{i=1}^{N} w_i\left(I_i^{fit}(v, m) - I_i(\theta)\right)^2 + \lambda T(v, m, \theta)$$

$$= \frac{1}{2}\sum_{i=1}^{N} w_i\left(H_{(i,:)}(m)v - I_i(\theta)\right)^2 + \lambda T(v, m, \theta) \qquad [21]$$

where $T(v, m, \theta)$ represents an optional regularization term or prior to enforce any secondary desirable behaviour over the unknowns vector (e.g., an L1 Tikhonov regularization to avoid values that are too large), and λ is a weighting factor for balancing between the cosine fitting and the regularization term (i.e., to set the regularization weight).

A suitable mathematical optimizer or solver for solving Equation [21] may comprise a multiple Newtonian or Quasi-Newtonian mathematical solver. If a set of linear, non-linear, and/or box constraints are required over all (or some) of the unknowns, Lagrangian multipliers-based methods, barrier methods and/or active-set based solvers may be used. Optionally, suitable variable transformations may also be applied to transform the constrained fitting problem into an unconstrained problem.

When a rotation angle θ is included in the model [20] and in the optimized functional [21], the mathematical solver

$$I(x_i', y_i') = I\left(R(\theta)\begin{bmatrix}x\\y\end{bmatrix}\right)$$

during line search iterations could query intensity profile values $I_i =$ along directions that are non-parallel with the original image coordinate system axes. The same applies for the Jacobian of the intensity image required for the first derivative computation of the transformation parameters. This requires an image interpolation kernel which is able to interpolate the intensity and the Jacobian at pixel off-grid positions. Multiple interpolators are available in literature which can be used for this purpose, such as bi-linear, B-Splines, and nearest neighbor interpolations.

It can be appreciated that both the model fitting and the extension of model fitting to incorporate one or more known tool induced distortions such as fringe magnification and/or fringe rotation may also be employed within the context of continuous diffraction-based overlay (cDBO), where the gratings in each layer have different pitches, the order of the gratings being reversed in two complementary targets (e.g., per direction). Due to the different pitches used on bottom and top gratings, interference fringes are created from 1st order light (+1/-1) only and visible on the resulting image. In all embodiments proposed throughout this specification, and therefore also in cDBO, the fitting methods may be employed to retrieve the phase $\varphi(OV)$ of each diffraction order. In such an example, the first-type sub-target may comprise the "M-type" sub-target which comprises the smaller pitch in the top layer and the second-type sub-target may comprise the "W-type" sub-target which comprises the larger pitch in the top layer. In such an example, the model of Equation [10] is essentially the same, other than the pitch p of that model being replaced by the Moiré pitch of the interference (beat) pattern generated from the two pitches of the component gratings. This Moiré pitch $P_m^W$, $P_m^M$ respectively for the "W-type" sub-target and "M-type" sub-target, can be computed as follows:

$$P_m^W = \frac{P_t^W P_b^W}{\left| P_t^W - P_b^W \right|} \qquad [22a]$$

$$P_m^M = \frac{P_t^M P_b^M}{\left| P_t^M - P_b^M \right|} \qquad [22b]$$

where the "W-type" sub-target has a bottom layer pitch $P_b^W$ and a top layer pitch $P_t^W$ and the "M-type" sub-target has a bottom layer pitch $P_b^M$ and a top layer pitch $P_t^M$. It can be mathematically shown that the overlay OV is related to the phase asymmetries of the "W-type" and "M-type" sub-targets of the normal N (i.e., +1 diffraction order) and complementary C (i.e., -1 diffraction order) dark-field images, with respective phase terms for the N and C images labelled $\varphi_N^W, \varphi_C^W, \varphi_N^M, \varphi_C^M$, such that:

$$OV = \frac{1}{4\pi} \cdot \frac{P_t^W P_t^M}{\left| P_t^W + P_t^M \right|} \left( \varphi_N^W + \varphi_C^W - \varphi_N^M - \varphi_C^M \right) [23].$$

Also applicable to the cDBO concepts are each of (in any combination or individually): the polynomial expansion of the DC term of the fitting model, the harmonic expansion of the oscillatory term and the application of a weighting window mask.

It can be appreciated that all mentions above of a positive biased sub-target and a negative biased sub-target in the above description may be generalized to a first biased sub-target and second biased sub-target. There is no requirement for the biases to comprise one positive and one negative bias (e.g., equal in magnitude or otherwise). Any different first bias and second bias can be used for a sub-target pair used to determine overlay for a particular measurement direction. It can also be appreciated that one of these biases may be a zero bias. Also, the targets may differ from those shown. For example, they may comprise only two sub-targets and measure overlay in only a single direction. Alternatively, they may comprise more than four sub-targets, e.g., to enable measurement of other nuisance parameters such as non-overlay target asymmetries. It can further be appreciated that all the specific arrangements shown are purely examples and there is a near infinite number of possible target arrangements which fall within the scope of the present disclosure. For example, a target arrangement may only comprise target regions for measuring in only a single direction. Also spacing can be added between the pads to counter crosstalk and/or parallax issues.

In association with the physical grating structures of the targets realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3(a) and/or the control unit LACU of Figure 2. There may also be provided a data storage medium (e.g., semiconductor memory, magnetic or optical disk) having such a computer program stored therein. Where an existing metrology apparatus, for example of the type shown in Figure 3(a), is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Although reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The following numbered clauses describe examples of the concepts disclosed herein:

1. A method of determining a respective representative measurement value for one or more regions of interest within at least one image of a metrology target representative of light diffracted by the target, the method comprising:

obtaining metrology data describing the at least one image;
fitting a model to the metrology data in the one or more regions of interest of the at least one image, the model comprising at least a zero frequency term and an oscillatory term; and
determining the representative measurement value for the one or more regions of interest from the fitted model.

2. The method according to clause 1, wherein the model models the zero frequency term as a constant term over each of the one or more regions of interest, and the representative measurement value for each of the one or more regions of interest is determined respectively to equal the respective fitted zero frequency term.

3. The method according to clause 1, wherein the model models the zero frequency as a constant term over each of the one or more regions of interest and the representative measurement value for each of the one or more regions of interest is determined respectively to equal the respective fitted oscillatory term.

4. The method according to clause 1, wherein the model models the zero frequency term as a two-dimensional spatial basis function expansion over a first direction and a second direction of each of the one or more regions of interest to obtain a fitted two-dimensional spatial basis function expanded zero frequency term.

5. The method according to clause 4, further comprising determining the representative measurement value for each of the one or more regions of interest from each respective fitted two-dimensional spatial basis function expanded zero frequency term.

6. The method according to clause 4, wherein the representative measurement value for each of the one or more regions of interest is determined respectively to equal the respective fitted oscillatory term.

7. The method according to any of preceding clauses 4 to 6, wherein the two-dimensional spatial basis function expansion comprises a two-dimensional radial basis function expansion, two-dimensional polynomial expansion or a combination thereof.

8. The method according to clauses 4, 5 or 7, wherein the representative measurement value for each of the one or more regions of interest is determined as an average of the fitted two-dimensional spatial basis function expanded zero frequency term.

9. The method according to any preceding clause, wherein the at least one image results from diffraction of a single order.

10. The method according to any preceding clause, wherein the at least one image comprises interference fringes, the interference fringes resulting from imaging of at least two non-zero diffraction orders.

11. The method according to clause 10, wherein the at least two non-zero diffraction orders are of different orders.

12. The method according to clause 10 or 11, wherein the at least one image comprises an image of only the at least two non-zero diffraction orders and substantially no zero diffraction order radiation.

13. The method according to any preceding clause, wherein each of the one of more regions of interest corresponds to a region of a respective different sub-target of the metrology target.

14. The method according to clause 13, wherein each sub-target comprises a first periodic structure having a first pitch in a first layer and a second periodic structure having said first pitch in a second layer.

15. The method according to clause 13, wherein each sub-target comprises a first periodic structure having a first pitch in a first layer and a second periodic structure having a second pitch in a second layer.

16. The method according to clause 14 or 15, wherein the metrology target comprises at least one pair of sub-targets, each sub-target of the at least one pair of sub-targets comprising a different respective bias between the first periodic structure and second periodic structure.

17. The method according to clause 16, wherein the metrology target comprises two pairs of sub-target, with one pair of sub-targets for each of a pair of measurement directions.

18. The method according to any preceding clause, wherein the at least one image comprises, for each metrology target of the one or more metrology targets, a normal image formed from at least two non-zero positive diffraction orders and a complementary image formed from at least two non-zero negative diffraction orders.

19. The method according to any preceding clause, wherein the model is arranged to define a linear system describing the metrology data, per pixel in at least a direction of periodicity of said interference fringes, in terms of a model matrix comprising known parameters and an unknowns vector comprising each said zero frequency term.

20. The method according to clause 19, wherein the method comprises solving the linear system for the unknowns vector by determining the pseudo-inverse of the model matrix.

21. The method according to any preceding clause, wherein the oscillatory term is modeled as a first harmonic only.

22. The method according to any of clauses 1 to 20, wherein the oscillatory term is modeled as multiple harmonics at period $p/i$ where p is a pitch of said interference fringes and i is an integer indexing said multiple harmonics.

23. The method according to any preceding clause, comprising applying a weighting window mask as an input to the fitting step.

24. The method according to clause 23, wherein the weighting window mask comprises an apodization or binary mask.

25. The method according to clause 23 or 24, wherein the weighting window mask is configured to suppress or reduce the contribution of edge pixels at a boundary of each region of interest.

26. The method according to any preceding clause, wherein the model additionally models one or more tool induced distortions.

27. The method according to clause 26, wherein the one or more tool induced distortions comprise one or both of fringe magnification and/or fringe rotation of the interference fringes.

28. The method according to clause 27, wherein the fringe rotation is modeled by incorporating a rotation matrix into the model.

29. The method according to clause 27 or 28, wherein the fringe magnification is modeled by incorporating a multiplicative magnification factor into the model.

30. The method according to any preceding clause, wherein the representative measurement value for each of the one or more regions of interest comprises a zero-frequency term or a phase term.

31. The method according to any preceding clause, comprising determining a parameter of interest from the representative measurement values as determined for the one or more regions of interest.

32. The method according to clause 31, wherein the parameter of interest comprises overlay, exposure focus or exposure dose.

33. The method according to clause 31 or 32, comprising determining a correction for a lithographic process from the determined parameter of interest.

34. The method according to any preceding clause, wherein the metrology data comprises measured intensity data at least within the one or more regions of interest.

35. The method according to any preceding clause, wherein the metrology target comprises a metrology target on a production substrate.

36. The method according to any of clauses 1 to 34, wherein the metrology target comprises a metrology target on a monitor substrate.

37. A computer program comprising program instructions operable to cause a metrology apparatus to perform the method of any of clauses 1 to 36, when run on a suitable apparatus.

38. A non-transient computer program carrier comprising the computer program of clause 37.

39. A processing arrangement comprising:

the non-transient computer program carrier of clause 38; and
a processor operable to run said computer program.

40. A metrology apparatus comprising the processing arrangement of clause 39.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of determining a respective representative measurement value for one or more regions of interest within at least one image of a metrology target representative of light diffracted by the target, the method comprising:

obtaining metrology data describing the at least one image,
fitting a model to the metrology data in the one or more regions of interest of the at least one image, the model comprising at least a zero frequency term and an oscillatory term; and

determining the representative measurement value for the one or more regions of interest from the fitted model.

2. The method according to claim 1, wherein the model models the zero frequency term as a constant term over each of the one or more regions of interest, and the representative measurement value for each of the one or more regions of interest is determined respectively to equal the respective fitted zero frequency term.

3. The method according to claim 1, wherein the model models the zero frequency as a constant term over each of the one or more regions of interest and the representative measurement value is determined respectively to equal the respective fitted oscillatory term.

4. The method according to any preceding claim, wherein the at least one image results from diffraction of a single order.

5. The method according to any preceding claim, wherein the at least one image comprises interference fringes resulting from imaging of at least two non-zero diffraction orders.

6. The method according to claim 5, wherein the at least two non-zero diffraction orders are of different orders.

7. The method according to any preceding claim, wherein each of the one of more regions of interest corresponds to a region of a respective different sub-target of the metrology target.

8. The method according to claim 7, wherein each sub-target comprises a first periodic structure having a first pitch in a first layer and a second periodic structure having said first pitch in a second layer.

9. The method according to claim 7, wherein each sub-target comprises a first periodic structure having a first pitch in a first layer and a second periodic structure having a second pitch in a second layer.

10. The method according to any of claims 5 to 9, wherein the model is arranged to define a linear system describing the metrology data, per pixel in at least a direction of periodicity of the interference fringes, in terms of a model matrix comprising known parameters and an unknowns vector comprising the zero frequency term.

11. The method as claimed in any preceding claim, wherein the model additionally models one or more tool induced distortions comprising one or both of fringe magnification and/or fringe rotation.

12. The method as claimed in any preceding claim, comprising determining a parameter of interest from the representative measurement values as determined for each of the one or more regions of interest.

13. The method as claimed in claim 12, wherein the parameter of interest comprises overlay, exposure focus or exposure dose.

14. A computer program comprising program instructions operable to cause a metrology apparatus to perform the method of any preceding claim, when run on a suitable apparatus.

15. A metrology apparatus comprising:

the computer program of claim 14; and

at least one processor operable to run said computer program.

Fig. 1

Fig. 2

Fig. 3

Fig. 4

Fig. 5

Fig. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242970 A
- US 2010201963 A1
- US 2011102753 A1
- US 12130246 B2